# EUROPÄISCHE PATENTSCHRIFT

(11) **EP 2 036 409 B1**
(45) Veröffentlichungstag und Bekanntmachung des Hinweises auf die Patenterteilung: **01.12.2010**
(21) Anmeldenummer: 07765509.0
(22) Anmeldetag: 20.06.2007
(51) Int. Cl.: H05K 1/02, H05K 1/14, H05K 9/00

(54) **ABSCHIRMELEMENT FÜR ELEKTRONIK-EINHEITEN**
SCREENING ELEMENT FOR ELECTRONIC UNITS
ÉLÉMENT DE BLINDAGE POUR MODULES ÉLECTRONIQUES

(30) Priorität: 23.06.2006 DE 102006028926
(43) Veröffentlichungstag der Anmeldung: 18.03.2009
(73) Patentinhaber: Robert Bosch GmbH, 70442 Stuttgart (DE)
(72) Erfinder: DILLMANN, Adolf, 72525 Muensingen (DE); SILBERBAUER, Achim, 72762 Reutlingen (DE); HUBER, Daniel, 72762 Reutlingen (DE)
(86) Internationale Anmeldenummer: PCT/EP2007/056111
(87) Internationale Veröffentlichungsnummer: WO 2007/147833

(56) Entgegenhaltungen:
- EP-A- 1 513 379
- WO-A-02/096177

## Beschreibung

Die Erfindung betrifft eine Anordnung, gebildet von einem Abschirmelement und mindestens zwei Elektronik-Einheiten, zwischen denen das Abschirmelement angeordnet ist.

### Stand der Technik

Zur Abschirmung von elektromagnetischen Feldern, wie sie zum Beispiel in Motoren, Steuergeräten und elektronischen Systemen auftreten, werden zwischen Elementen, die ein elektromagnetisches Feld generieren, häufig Trennwände, Absorbermaterial und/oder Filterstrukturen eingebracht. Oftmals werden diese Elemente zur Abschirmung auch in unterschiedlichen Kammern angeordnet. Aus Fertigungs- und Kostengründen sind die, die elektromagnetischen Felder abschirmenden Trennwände, gerade ausgebildet. Eine solche Anordnung wird in EP 1 513 379 A2 beschrieben. Sind beispielsweise in einem Steuergerät zwei Leiterplatten parallel zueinander angeordnet, wobei die Seiten der Leiterplatten, auf denen elektronische Bauteile angeordnet sind, zueinander ausgerichtet sind, soll zwischen den Leiterplatten zur elektronmagnetischen Abschirmung eine Trennwand angeordnet werden. Um kein elektronisches Bauteil auf einer der Leiterplatten zu beschädigen, muss die Trennwand einen Abstand zu den Leiterplatten aufweisen, der mindestens so groß ist, wie das am weitesten von der jeweiligen Leiterplatte abstehende Bauteil. Dadurch entstehen in Bereichen mit kleineren Bauteilen Freiräume, die nicht weiter genutzt werden.

### Offenbarung der Erfindung

Erfindungsgemäß ist vorgesehen, dass die Elektronik-Einheiten in Überlappungsposition zueinander stehen und dass das Abschirmelement winkelförmig zwischen den Elektronik-Einheiten verläuft. Betrachtet man zwei Elektronik-Einheiten aus einem bestimmten Blickwinkel, so wird die eine Elektronik-Einheit von der anderen zumindest teilweise verdeckt. Betrachtet man zum Beispiel zwei Leiterplatten, die parallel zueinander angeordnet sind und auf deren einander zugewandten Seiten jeweils eine oder mehrere Elektronik-Einheiten angeordnet sind, aus einem Blickwinkel parallel zu den Leiterplatten, so können Elektronik-Einheiten auf der einen Leiterplatte von Elektronik-Einheiten auf der anderen Leiterplatte zumindest teilweise verdeckt werden. Diese Anordnung ist vorteilhaft insofern, als dass zwischen den Leiterplatten bestehende Freiräume optimal ausgenutzt werden können. Diese Anordnung beziehungsweise diese Ausnutzung des Bauraums ist nicht möglich mit geraden Trennwänden aus dem Stand der Technik. Um dennoch eine Abschirmung der elektromagnetischen Felder der Elektronik-Einheiten zu gewährleisten, ist das erfindungsgemäße Abschirmelement vorgesehen, welches winkelförmig zwischen den Elektronik-Einheiten verläuft. Wobei nicht allein ein knickförmiger Verlauf als winkelförmiger Verlauf in dem Abschirmelement verstanden werden soll, sondern jeglicher formbildender Verlauf des Abschirmelements, sei er knick- und/oder kurvenförmig. Durch den winkelförmigen Verlauf kann das Abschirmelement optimal an die Anordnung der Elektronik-Einheiten angepasst werden, sodass auch Elektronik-Einheiten, die in Überlappungsposition zueinander stehen, voneinander abgeschirmt werden. Natürlich muss der winkelförmige Verlauf nicht über die gesamte Breite des Abschirmelements ausgebildet sein, vielmehr ist vorteilhafterweise vorgesehen, dass durch den winkelförmigen Verlauf in dem Abschirmelement lokale Erhöhungen und/oder Vertiefungen gebildet werden. Um vorhandenen Bauraum optimal zu nutzen sind die Elektronikeinheiten so angeordnet, dass möglichst kleine ungenutzte Freiräume entstehen.

Vorteilhafterweise weist das Abschirmelement zu zwei gegenüberliegenden Elektronik-Einheiten jeweils den gleichen Abstand auf. Durch diese symmetrische Anordnung des Abschirmelements zu den Elektronik-Einheiten ist eine besonders starke Isolierung der elektromagnetischer Felder zueinander möglich. Zweckmäßigerweise beträgt der Abstand zwischen den zwei gegenüberliegenden Elektronik-Einheiten mindestens 1 mm. Dadurch entsteht zum einen eine sehr kompakte Auslegung des Bauraums, und zum anderen verhindert der Mindestabstand, dass das Abschirmelement bei auftretenden Vibrationen und/oder Schlägen und/oder durch temperaturbedingte Verformungen nicht mit einer Elektronik-Einheit in direkten Kontakt kommt.

Nach einer Weiterbildung der Erfindung ist das Abschirmelement an ein Potential einer der Elektro-Einheiten gelegt. Dies erlaubt einen Schutz vor elektrostatischen Entladungen (ESD-Schutz) und sichert einen zuverlässigen Potentialausgleich.

Nach einer Weiterbildung der Erfindung ist mindestens eine Elektronik-Einheit in einem Gehäuse angeordnet. Dadurch können eine oder mehrere Elektronik-Einheiten auf einfache Art und Weise bei der Montage gehandhabt werden.

Vorteilhafterweise ist das Abschirmelement als Abschirmplatte ausgebildet. Zweckmäßigerweise ist die Abschirmplatte aus Metall gefertigt. Zusätzlich wirkt die Abschirmplatte als Flitterschutz, sodass beispielsweise Schmutzpartikel nicht von einer Leiterplatte auf die andere fallen und dort Fehlfunktionen verursachen können.

Erfindungsgemäß ist die Abschirmplatte über Mittel lösbar an dem Gehäuse befestigt. Dadurch kann das Gehäuse mit der einen oder den mehreren Elektronik-Einheiten und der Abschirmplatte vormontiert und als bereits elektromagnetisch abgeschirmte Baugruppe verwendet werden. Vorteilhafterweise ist die Abschirmplatte dabei als Abschirmdeckel, der das Gehäuse mit der darin befindlichen Elektronik-Einheit verschließt, ausgebildet.

Nach einer Weiterbildung der Erfindung weist das Gehäuse als Mittel zum lösbaren Befestigen mindestens einen Zapfen auf. Dieser ist vorteilhafterweise kegelförmig und zweckmäßigerweise einstückig mit dem Gehäuse ausgebildet.

Vorteilhafterweise weist die Abschirmplatte als Mittel mindestens eine Aussparung auf, die den Zapfen aufnimmt. Auf diese Art und Weise kann die Abschirmplatte einfach an dem Gehäuse positioniert werden. Durch eine entsprechende Gestaltung des Zapfens und der Aussparung wird dabei auch eine Befestigung der Abschirmplatte an dem Gehäuse ermöglicht.

Vorteilhafterweise ist die Aussparung als Durchbruch ausgebildet, sodass der Zapfen durch den Durchbruch gesteckt werden kann. Weist der Zapfen an seinem freien Ende einen vergrößerten Durchmesser auf und ist der Zapfen an diesem Ende in Längsrichtung geschlitzt, so wirkt er als Rastelement. Der Durchbruch ist zweckmäßigerweise als Bohrung ausgebildet.

Nach einer Weiterbildung der Erfindung weist die Abschirmplatte mindestens ein Schwingungs- und/oder Dämpfungselement auf. Das Schwingungs- und/oder Dämpfungselement dient dazu, dass die Abschirmplatte sich aufgrund von Temperaturänderungen verformen und/oder aufgrund von Vibrationen oder ähnlichem bewegen kann, sodass ein Abscheren des Zapfens verhindert wird. Unter anderem wird so auch eine Zugbelastung auf die Abschirmplatte verringert.

Nach einer Weiterbildung der Erfindung ist das Schwingungselement als Schwingungszunge beziehungsweise das Dämpfungselement als Dämpfungszunge an der Abschirmplatte ausgebildet. Die vorteilhafterweise einstückig mit der Abschirmplatte ausgebildete Schwingungs- beziehungsweise Dämpfungszunge kann auf einfache Art und Weise in einem Schritt mit dem Abschirmblech aus einem Grundmaterial ausgestanzt werden. In einem weiteren Schritt wird anschließend die Schwingungs- beziehungsweise Dämpfungszunge so gebogen, dass sie ihre Schwingungs- beziehungsweise Dämpfungsfunktion erhält.

Vorteilhafterweise ist die Aussparung in der Schwingungs- oder Dämpfungszunge ausgebildet. Damit ist das Schwingungsbeziehungsweise Dämpfungselement gleichzeitig auch Halteelement für die Abschirmplatte. Vorteilhafterweise sind mindestens drei dieser Halteelemente an der Abschirmplatte und eine entsprechende Anzahl von Zapfen an dem Gehäuse über den Umfang der Abschirmplatte verteilt angeordnet, sodass die Abschirmplatte mechanisch von dem Gehäuse entkoppelt ist.

Erfindungsgemäß ist als Elektronik-Einheit ein elektronisches Bauteil vorgesehen. Ein elektronisches Bauteil kann zum Beispiel ein Kondensator, ein Widerstand oder auch ein Leitelement wie ein Kabel oder ein Stanzgitter sein.

Nach einer Weiterbildung der Erfindung ist als Elektronik-Einheit eine aus mehreren elektronischen Bauteilen bestehende Baugruppe vorgesehen. Diese kann zum Beispiel ein Motor, ein Netzteil oder eine Leiterplatte sein, auf der Elektronik-Bauteile angeordnet sind. Die Erfindung betrifft also sowohl einzelne in Überlappungsposition stehende Bauteile, wie auch in Überlappungsposition stehende Baugruppen.

Nach einer Weiterbildung der Erfindung weist die Abschirmplatte mindestens eine Sicke auf, die durch den winkelförmigen Verlauf der Abschirmplatte gebildet wird. Zum einen kann die Sicke zur Bauraumeinsparung im Sinne der Erfindung dienen, und zum anderen wirkt die Sicke wegen ihrer Versteifung zusätzlich als Schwingungsdämpfer bei auftretenden Vibrationen und/oder wenn zum Beispiel ein Gerät, in dem sich die erfindungsgemäße Anordnung befindet, geschüttelt wird. Besonders vorteilhaft ist es dabei, wenn mehrere Sicken in ihrer Längserstreckung orthogonal zueinander ausgerichtet sind.

Ferner betrifft die Erfindung eine elektronische Baueinheit, bestehend aus einem Gehäuse, mindestens eine Elektronik-Einheit und einem Abschirmelement nach einem der vorhergehenden Ansprüche.

Vorteilhafterweise ist dabei das Abschirmelement als Abschirmplatte oder als Abschirmdeckel ausgebildet, wobei sich die Elektronik-Einheit in dem von der Abschirmplatte beziehungsweise dem Abschirmdeckel zumindest teilweise verschlossenen Gehäuse befindet. Diese elektronische Baueinheit kann als vormontierte Einheit bei einer Montage verwendet werden. Dabei weist die elektronische Baueinheit bereits eine Abschirmung gegen elektromagnetische Felder auf.

### Kurze Beschreibung der Zeichnungen

Im Folgenden soll die Erfindung anhand einiger Figuren näher erläutert werden. Dabei zeigen
- Figur 1: eine Anordnung von mehreren Elektronik-Einheiten und einem Abschirmelement aus dem Stand der Technik,
- Figur 2: eine erfindungsgemäße Anordnung mit mehreren Elektronik-Einheiten und einem Abschirmelement,
- Figur 3: eine erfindungsgemäße Baueinheit in einer perspektivischen Darstellung,
- Figur 4: das erfindungsgemäße Abschirmblech aus Figur 3 in einer Draufsicht,
- Figur 5: die erfindungsgemäße Baueinheit aus Figur 3 in einer Draufsicht und
- Figur 6: eine Schnittdarstellung eines erfindungsgemäßen Ausführungsbeispiels.

### Ausführungsform(en) der Erfindung

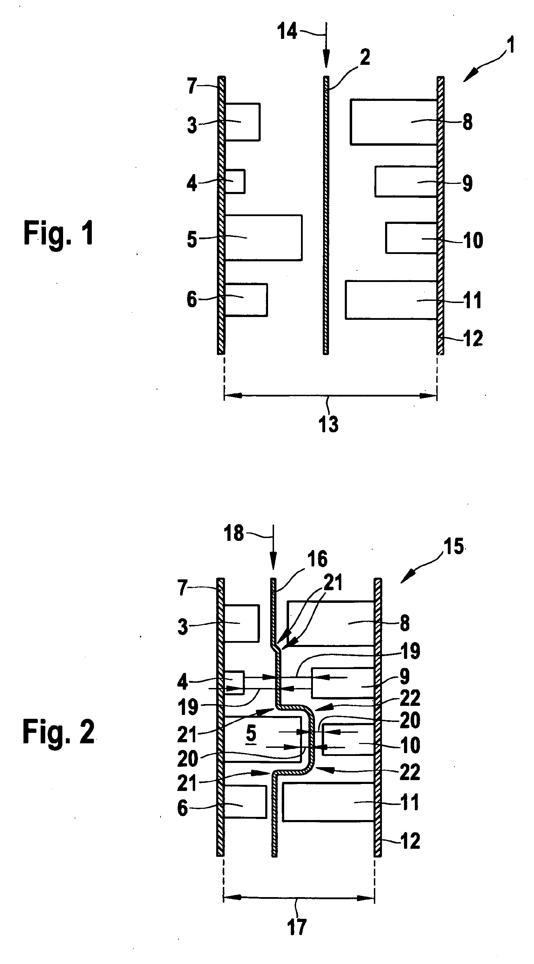

Die Figur 1 zeigt eine schematische Anordnung 1 aus dem Stand der Technik mit einem Abschirmelement 2, und vier Elektronik-Einheiten 3, 4, 5 und 6, die links von dem Abschirmelement 2 an einer Leiterplatte 7 angeordnet sind, und vier Elektronik-Einheiten 8, 9, 10 und 11, die rechts von dem Abschirmelement 2 an einer Leiterplatte 12 angeordnet sind, wobei die Leiterplatten 7 und 12 parallel zu dem Abschirmelement 2 ausgerichtet sind. Die Elektronik-Einheiten 3 bis 6 und 8 bis 11 sind dabei unterschiedlich groß ausgebildet, und stehen unterschiedlich weit von den jeweiligen Leiterplatten ab, wobei zum Beispiel die Elektronik-Einheiten 8, 5 und 11 größer ausgebildet sind als die Elektronik-Einheiten 4, 6 und 9.

Das Abschirmelement 2 dient dazu, elektromagnetische Felder der Elektronik-Einheiten 3 bis 6 und 8 bis 11 voneinander abzuschirmen. Die Elektronik-Einheiten 5 und 8, welche am weitesten von der Leiterplatte 7 beziehungsweise 12 abstehen, bestimmen dabei den Abstand der Leiterplatten 7 beziehungsweise 12 zu dem Abschirmelement 2, sodass sich ein Abstand 13 zwischen den Leiterplatten 7 und 12 ergibt. Zwischen den kleineren Elektronik-Einheiten 4, 6 und 9 und dem Abschirmelement 2 entstehen dabei nicht nutzbare Freiräume.

Betrachtet man die Anordnung 1 aus Richtung des Pfeiles 14, so wird keine Elektronik-Einheit 3 bis 6 von einer Elektronik-Einheit 8 bis 11 verdeckt. Die Elektronik-Einheiten 3 bis 6 und 8 bis 11 stehen also nicht in Überlappungsposition zueinander.

Die Figur 2 zeigt schematisch in einem erfindungsgemäßen Ausführungsbeispiel eine Anordnung 15 mit einem Abschirmelement 16 und den Elektronik-Einheiten 3 bis 6 aus der Figur 1, die an der Leiterplatte 7 links von dem Abschirmelement 16 angeordnet sind, und den Elektronik-Einheiten 8 bis 11 aus der Figur 1, die an der Leiterplatte 12 rechts von dem Abschirmelement 16 angeordnet sind. Die Leiterplatten 7 und 12 weisen dabei einen Abstand 17 zueinander auf, der kleiner ist als der Abstand 13 der Anordnung 1, wodurch, wenn man die Anordnung 15 aus Richtung des Pfeils 18 betrachtet, die Elektronik-Einheit 5 teilweise von der Elektronik-Einheit 8 und die Elektronik-Einheit 11 teilweise von der Elektronik-Einheit 5 verdeckt wird. Die Elektronik-Einheiten 8, 5 und 11 stehen dabei also in Überlappungsposition. Das Abschirmelement 16 verläuft dabei winkelförmig zwischen den Elektronik-Einheiten 3 bis 6 und 8 bis 12 und weist dabei zu gegenüberliegenden Elektronik-Einheiten, wie zum Beispiel 4 und 9 oder 5 und 10, jeweils den gleichen Abstand 19 beziehungsweise 20 auf.

Durch die erfindungsgemäße Anordnung 15 wird ein Gesamtraumbedarf und ungenutzter Freiraum verringert, da die Leiterplatten 7 und 12 einen kleineren Abstand 17 zueinander aufweisen als im Stand der Technik. Durch die symmetrische Auslegung des Abschirmelements 16 wird eine besonders hohe Isolationswirkung zwischen den Elektronik-Einheiten erreicht. Das winkelförmig verlaufende Abschirmelement 16 weist dabei Knicke 21 und kurvenförmige Bereiche 22 auf.

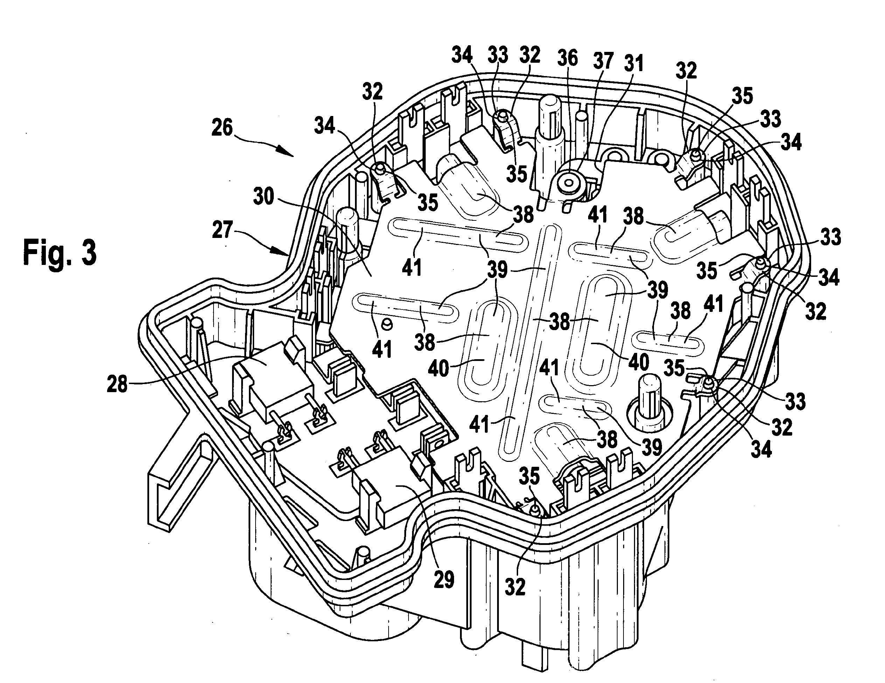

Die Figur 3 zeigt in einer perspektivischen Darstellung ein Ausführungsbeispiel einer elektronischen Baueinheit 26. Gezeigt ist ein Gehäuse 27, an dem Elektronik-Einheiten 28 und 29 und eine Abschirmplatte 30 angeordnet sind. In dem durch das Gehäuse 27 und die Abschirmplatte 30 gebildeten Raum sind weitere, hier nicht erkennbare, Elektronik-Einheiten angeordnet. Die Abschirmplatte weist an ihrem Umfang 31 mehrere Haltezungen 32 auf. Die Haltezungen 32 sind dabei so gestaltet, dass ihr Endbereich 33 in einer anderen Ebene liegt als die Abschirmplatte 30. Bei der Herstellung der Abschirmplatte 30 wird diese zunächst aus einem Grundmaterial, wie zum Beispiel einem Blech, gestanzt, wobei auch die Grundform der Haltezungen 32 mit ausgestanzt wird. In einem weiteren Schritt werden die Haltezungen 32 hochgebogen und in einem dritten Schritt der Endbereich 33 der Haltezungen 32 so gebogen, dass er in etwa parallel zu der Abschirmplatte 30 liegt. Im Endbereich 33 der Kontaktzungen 32 ist als Aussparung eine Durchbohrung 34 ausgebildet. Es sei hier angemerkt, dass aus Gründen der Übersichtlichkeit, in den jeweiligen Figuren gleiche Elemente nur teilweise mit Bezugszeichen versehen sind.

Das Gehäuse weist, im Wesentlichen kegelförmige, Zapfen 35 auf, die in die Durchbohrungen 34 der Haltezungen 32 geführt sind. Die Abschirmplatte 30 kann also auf andere Art und Weise mittels einer durch die Zapfen 35 und die Haltezungen 32 gebildete Steckverbindung an dem Gehäuse 27 positioniert und/oder befestigt werden. Die gebogenen Haltezungen 32 dienen dabei dazu, dass sich die Abschirmplatte 30 zum Beispiel aufgrund von Temperaturveränderungen verformen kann, ohne dass hohe Belastungen in den Steckverbindungen entstehen, die zu einem Abscheren des Zapfens 35 führen könnten. Zugbelastungen, beispielsweise, werden dadurch in der Abschirmplatte 30 zumindest verringert. Natürlich ist es auch denkbar, eine Zugentlastung im Gehäuse zu realisieren. Die gebogenen Haltezungen 32 dienen außerdem dazu, die Abschirmplatte 30 mechanisch von dem Gehäuse 27 zu entkoppeln, damit mechanische Schwingungen/Vibrationen nicht auf die Abschirmplatte 30 übertragen werden.

Die Abschirmplatte 30 weist eine weitere Zunge 36 auf, deren Endbereich 37 zwar ebenfalls parallel zu der Abschirmplatte 30 angeordnet ist, jedoch auf der den Endbereichen 33 der Haltezungen 32 gegenüberliegenden Seite der Abschirmplatte 30 befindet. Die Zunge 36 kontaktiert dabei elektrisch das Potential einer am Gehäuse 27 angeordneten Elektronik-Einheit. Dadurch wird ein Schutz vor statischen Entladungen realisiert und ein zuverlässiger Potentialausgleich gesichert.

Die Abschirmplatte 30 weist mehrere Erhöhungen 38 auf, von denen einige als Sicken 39 ausgebildet sind. Ein Teil der Erhöhungen 38 dienen als Sicken 40 zu einer vorteilhaften Anpassung der Abschirmplatte 30 zu darunter gelegenen Elektronik-Einheiten, sodass vorhandener Bauraum optimal ausgenutzt wird. Andere Erhöhungen 38 dienen als Sicken 41 zur Versteifung und als zusätzliche Schwingungsdämpfer. Wird die Baueinheit 26 zum Beispiel auf einer Leiterplatte, auf der ebenfalls Elektro-Einheiten angeordnet sind, angeordnet, so verläuft die Abschirmplatte zwischen den Elektronik-Einheiten der Leiterplatte und des Gehäuses 27 winkelförmig.

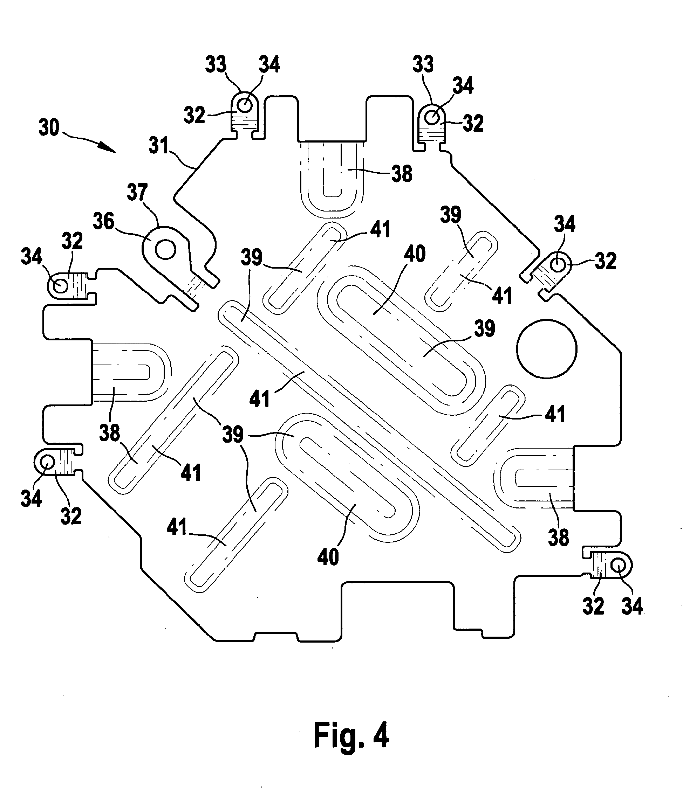

Figur 4 zeigt die Abschirmplatte 30 in einer Draufsicht. Deutlich zu erkennen sind dabei die Haltezungen 32, die am Umfang der Abschirmplatte 30 angeordnet sind sowie die Zunge 36, die ebenfalls am Umfang 31 der Abschirmplatte 30 angeordnet ist. Die orthogonale Ausrichtung der Sicken 39 ermöglicht eine besonders gute Schwingungsdämpfung.

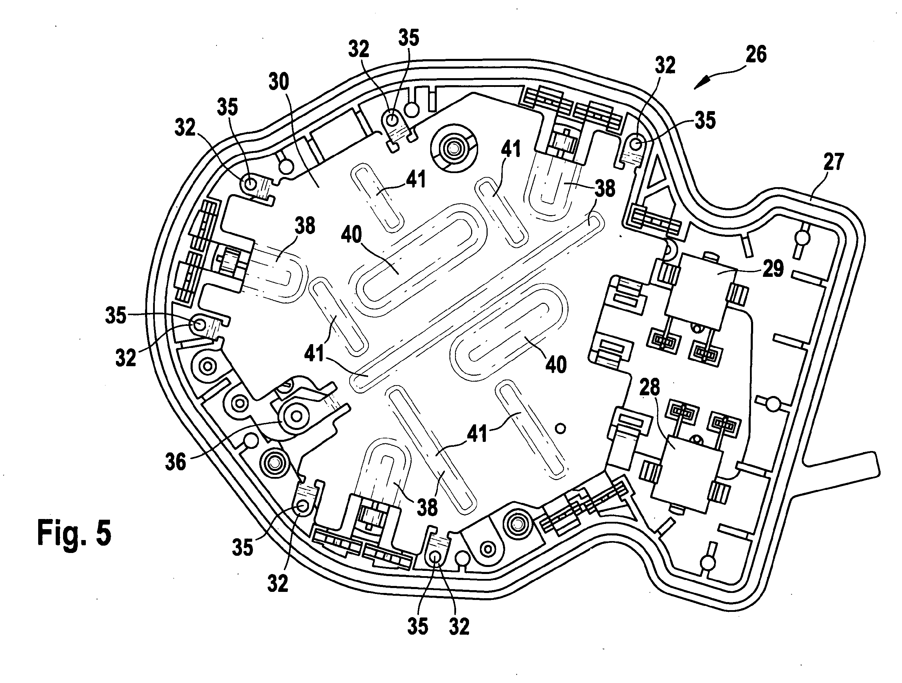

Die Figur 5 zeigt in einer Draufsicht die Baueinheit 26 aus der Figur 3.

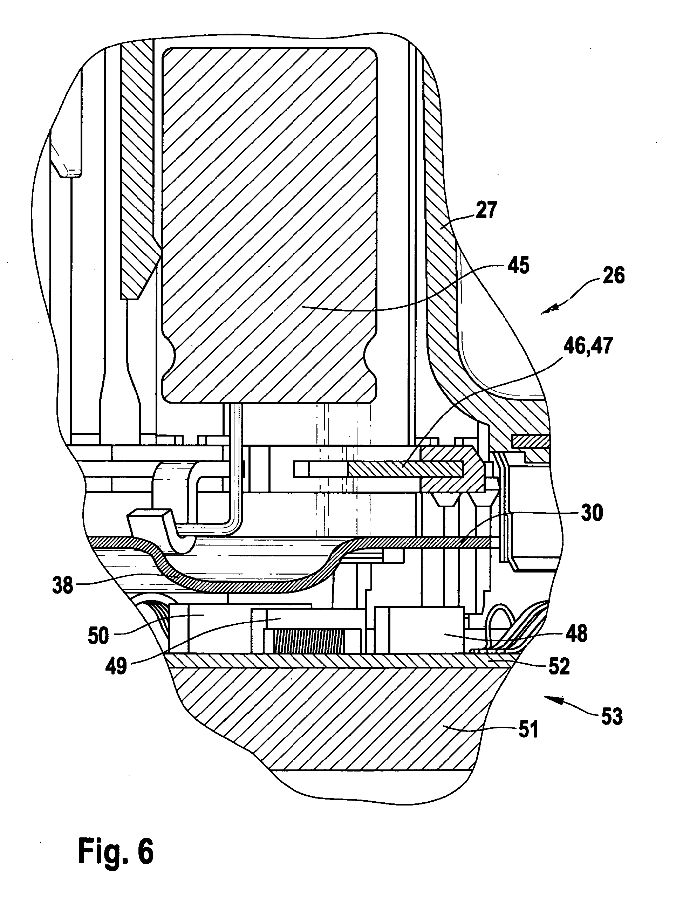

Die Figur 6 zeigt eine Schnittdarstellung eines weiteren Ausführungsbeispiels der Erfindung. Gezeigt ist das Gehäuse 27 aus der Figur 3 mit einer daran angeordneten Elektronik-Einheit 45 und einem Elektronikbauteil 46, wobei hier als Elektronik-Bauteil ein Stanzgitter 47 vorgesehen ist. Im unteren Bereich weist das Gehäuse 27 die daran befestigte Abschirmplatte 30 auf, in der eine Erhöhung beziehungsweise Vertiefung 38 ausgebildet ist. Soweit entspricht der Aufbau der Baueinheit 26 aus der Figur 3.

Unter der Abschirmplatte 30 sind weitere Elektronik-Einheiten 48, 49 und 50 angeordnet. Wobei als Leistungselektronik ausgebildete Elektronik-Einheiten 48, 49 und/oder 50 auf einem IMS (insulated metal substrate) oder einem DBC (direct bonded copper) aufgebracht und mit einem Kühlkörper 51 verbunden sind. Als Steuerelektronik ausgebildete Elektronik-Einheiten 48, 49 und/oder 50 sitzen auf dem Kühlkörper 51, und bestehen zum Beispiel aus einer Leiterplatte, HTCC (high temperature cofired ceramic) oder LTCC (low temperature cofired ceramic).

Auf dem Kühlkörper 51 wird ein Gehäuserahmen 52 befestigt. Auf der Einheit 53, bestehend aus Kühlkörper 51, Elektronik-Einheit 48, 49 und 50 und dem Gehäuserahmen 52 ist die Baueinheit 26 befestigt. Durch die Abschirmplatte 30 werden die elektromagnetischen Felder der Elektronik-Einheiten 45, 46 und 48 bis 50 voneinander abgeschirmt, bei gleichzeitiger optimaler Ausnutzung des vorhandenen Bauraums durch die Erhöhungen beziehungsweise Vertiefungen 38.

In dem Gehäuse 27 ist das Abschirmblech 30 durch mechanischen Kontakt direkt mit einem Pol eines am Gehäuse angeordneten Steckers verbunden. Eine elektrische Verbindung zu den Elektronik-Einheiten 48 bis 50 wird über Schneidklemmverbindungen und interne Verbindungen in den Elektronik-Einheiten 48 bis 50 erstellt. Damit entsteht ein niederohmiger Pfad von dem Stecker zu den Elektronik-Einheiten 48 bis 50, an die auch das Abschirmblech 30 über die Zunge 36 angebunden ist.

Durch diese Art der elektromagnetischen Abschirmung ist es zum Beispiel möglich, einen Hochstrommotor und eine Stromverteilung auf Stanzgittern in unmittelbarer Nähe zu einem magnetischen Sensor zu platzieren, wobei der Sensor zum Beispiel zur Detektion der Rotorlage eines Rotors des Hochstrommotors genutzt wird.

## Patentansprüche

1. Anordnung, gebildet von einem Abschirmelement und mindestens zwei Elektronik-Einheiten, zwischen denen das Abschirmelement angeordnet ist, **dadurch gekennzeichnet, dass** die Elektronik-Einheiten (8,5,11) in Überlappungsposition zueinander stehen und dass das Abschirmelement (16) winkelförmig zwischen den Elektronik-Einheiten (8,5,11) verläuft.

2. Anordnung nach Anspruch 1, **dadurch gekennzeichnet, dass** das Abschirmelement (16) zu zwei gegenüberliegenden Elektronik-Einheiten (4,9,5,10) jeweils den gleichen Abstand (19,20) aufweist.

3. Anordnung nach einem der vorhergehenden Ansprüche, **dadurch gekennzeichnet, dass** der Abstand zwischen den zwei gegenüberliegenden Elektronik-Einheiten (3,8,4,9,5,10,6,11) mindestens 1 mm beträgt.

4. Anordnung nach einem der vorhergehenden Ansprüche, **dadurch gekennzeichnet, dass** das Abschirmelement (16) an ein Potential einer der Elektronik-Einheiten gelegt ist.

5. Anordnung nach einem der vorhergehenden Ansprüche, **dadurch gekennzeichnet, dass** mindestens eine Elektronik-Einheit (45,46) in einem Gehäuse (27) angeordnet ist.

6. Anordnung nach einem der vorhergehenden Ansprüche, **dadurch gekennzeichnet, dass** das Abschirmelement, als Abschirmplatte (30) ausgebildet ist.

7. Anordnung nach einem der vorhergehenden Ansprüche, **dadurch gekennzeichnet, dass** die Abschirmplatte (30) über Mittel lösbar an dem Gehäuse (27) befestigt ist.

8. Anordnung nach einem der vorhergehenden Ansprüche, **dadurch gekennzeichnet, dass** das Gehäuse (27) als Mittel mindestens einen Zapfen (35) aufweist.

9. Anordnung nach einem der vorhergehenden Ansprüche, **dadurch gekennzeichnet, dass** die Abschirmplatte (30) als Mittel mindestens eine Aussparung aufweist, die den Zapfen (35) zumindest teilweise aufnimmt.

10. Anordnung nach einem der vorhergehenden Ansprüche, **dadurch gekennzeichnet, dass** die Aussparung als Durchbruch ausgebildet ist.

11. Anordnung nach einem der vorhergehenden Ansprüche, **dadurch gekennzeichnet, dass** die Abschirmplatte (30) mindestens ein Schwingungs- und/oder Dämpfungselement aufweist.

12. Anordnung nach einem der vorhergehenden Ansprüche, **dadurch gekennzeichnet, dass** das Schwingungselement als Schwingungszunge und das Dämpfungselement als Dämpfungszunge ausgebildet ist.

13. Anordnung nach einem der vorhergehenden Ansprüche, **dadurch gekennzeichnet, dass** die Aussparung in der Schwingungs- und/oder Dämpfungszunge ausgebildet ist.

14. Anordnung nach einem der vorhergehenden Ansprüche, **dadurch gekennzeichnet, dass** als Elektronik-Einheit ein elektronisches Bauteil (46) vorgesehen ist.

15. Anordnung nach einem der vorhergehenden Ansprüche, **dadurch gekennzeichnet, dass** als Elektronik-Einheit eine, aus mehreren elektronischen Bauteilen bestehende Baugruppe vorgesehen ist.

16. Anordnung nach einem der vorhergehenden Ansprüche, **dadurch gekennzeichnet, dass** in der Abschirmplatte (30) mindestens eine Sicke (39,40,41) ausgebildet ist.

17. Elektronische Baueinheit, bestehend aus einem Gehäuse (27), mindestens einer Elektronik-Einheit (45) und einer Anordnung (16) nach einem der vorhergehenden Ansprüche.

18. Elektronische Baueinheit nach Anspruch 17, **dadurch gekennzeichnet, dass** das Abschirmelement als Abschirmplatte (30) ausgebildet ist.

## Claims

1. Arrangement, formed by a screening element and at least two electronic units between which the screening element is arranged, **characterized in that** the electronic units (8, 5, 11) are in an overlapping position with respect to one another, and **in that** the screening element (16) runs in angular fashion between the electronic units (8, 5, 11).

2. Arrangement according to Claim 1, **characterized in that** the screening element (16) is in each case at the same distance (19, 20) from two opposite electronic units (4, 9, 5, 10).

3. Arrangement according to either of the preceding claims, **characterized in that** the distance between the two opposite electronic units (3, 8, 4, 9, 5, 10, 6, 11) is at least 1 mm.

4. Arrangement according to any of the preceding claims, **characterized in that** the screening element (16) is connected to a potential of one of the electronic units.

5. Arrangement according to any of the preceding claims, **characterized in that** at least one electronic unit (45, 46) is arranged in a housing (27).

6. Arrangement according to any of the preceding claims, **characterized in that** the screening element is embodied as a screening plate (30).

7. Arrangement according to any of the preceding claims, **characterized in that** the screening plate (30) is releasibly fixed to the housing (27) by means.

8. Arrangement according to any of the preceding claims, **characterized in that** the housing (27) has at least one pin (35) as means.

9. Arrangement according to any of the preceding claims, **characterized in that** the screening plate (30) has, as means, at least one cutout which at least partly receives the pin (35).

10. Arrangement according to any of the preceding claims, **characterized in that** the cutout is embodied as a perforation.

11. Arrangement according to any of the preceding claims, **characterized in that** the screening plate (30) has at least one oscillating and/or damping element.

12. Arrangement according to any of the preceding claims, **characterized in that** the oscillating element is embodied as an oscillating tongue and the damping element is embodied as a damping tongue.

13. Arrangement according to any of the preceding claims, **characterized in that** the cutout is formed in the oscillating and/or damping tongue.

14. Arrangement according to any of the preceding claims, **characterized in that** an electronic component (46) is provided as an electronic unit.

15. Arrangement according to any of the preceding claims, **characterized in that** an assembly consisting of a plurality of electronic components is provided as an electronic unit.

16. Arrangement according to any of the preceding claims, **characterized in that** at least one bead (39, 40, 41) is formed in the screening plate (30).

17. Electronic structural unit, consisting of a housing (27), at least one electronic unit (45) and an arrangement (16) according to any of the preceding claims.

18. Electronic structural unit according to Claim 17, **characterized in that** the screening element is embodied as a screening plate (30).

## Revendications

1. Système formé d'un élément de blindage et d'au moins deux unités électroniques entre lesquelles l'élément de blindage est disposé, **caractérisé en ce que** les unités électroniques (8, 5, 11) sont superposées l'une à l'autre et **en ce que** l'élément de blindage (16) s'étend en coude entre les unités électroniques (8, 5, 11).

2. Système selon la revendication 1, **caractérisé en ce que** l'élément de blindage (16) présente la même distance (19, 20) par rapport aux deux unités électroniques (4, 9, 5, 10) opposées l'une à l'autre.

3. Système selon l'une des revendications précédentes, **caractérisé en ce que** la distance entre les deux unités électroniques (3, 8, 4, 9, 5, 10, 6, 11) opposées l'une à l'autre est d'au moins 1 mm.

4. Système selon l'une des revendications précédentes, **caractérisé en ce que** l'élément de blindage (16) est placé à un potentiel d'une des unités électroniques.

5. Système selon l'une des revendications précédentes, **caractérisé en ce qu'**au moins une unité électronique (45, 46) est disposée dans un boîtier (27).

6. Système selon l'une des revendications précédentes, **caractérisé en ce que** l'élément de blindage est configuré comme plaque de blindage (30).

7. Système selon l'une des revendications précédentes, **caractérisé en ce que** la plaque de blindage (30) est fixée de manière libérable sur le boîtier (27) par un moyen.

8. Système selon l'une des revendications précédentes, **caractérisé en ce que** le boîtier (27) présente comme moyen au moins un tourillon (35).

9. Système selon l'une des revendications précédentes, **caractérisé en ce que** la plaque de blindage (30) présente comme moyen au moins une découpe qui reprend au moins une partie du tourillon (35).

10. Système selon l'une des revendications précédentes, **caractérisé en ce que** la découpe est configurée comme perforation.

11. Système selon l'une des revendications précédentes, **caractérisé en ce que** la plaque de blindage (30) présente au moins un élément oscillant et/ou d'amortissement.

12. Système selon l'une des revendications précédentes, **caractérisé en ce que** l'élément oscillant est configuré comme languette oscillante et l'élément d'amortissement comme languette d'amortissement.

13. Système selon l'une des revendications précédentes, **caractérisé en ce que** la découpe est formée dans la languette oscillante et/ou la languette d'amortissement.

14. Système selon l'une des revendications précédentes, **caractérisé en ce qu'**un composant électronique (46) est prévu comme unité électronique.

15. Système selon l'une des revendications précédentes, **caractérisé en ce qu'**un module constitué de plusieurs composants électroniques est prévu comme unité électronique.

16. Système selon l'une des revendications précédentes, **caractérisé en ce qu'**au moins une moulure (39, 40, 41) est formée dans la plaque de blindage (30).

17. Module électronique constitué d'un boîtier (27), d'au moins une unité électronique (45) et d'un système (16) selon l'une des revendications précédentes.

18. Module électronique selon la revendication 17, **caractérisé en ce que** l'élément de blindage est configuré comme plaque de blindage (30).
